# EUROPEAN PATENT APPLICATION

(11) **EP 4 579 256 A1**
(43) Date of publication of application: **02.07.2025**
(21) Application number: 24172774.2
(22) Date of filing: 26.04.2024
(51) Int. Cl.: G01R 31/367, G01R 31/382

(54) **METHOD AND APPARATUS FOR CORRECTING CAPACITY OF BATTERY MODULE, AND COMPUTER DEVICE**

(30) Priority: 27.12.2023 CN 202311830576
(71) Applicant: Sungrow Power Supply Co., Ltd., Hefei, Anhui 230088 (CN)
(72) Inventor: HU, Yongbing, Hefei, 230088 (CN); LIANG, Dongyu, Hefei, 230088 (CN)
(74) Representative: Rooney, John-Paul

(57) **Abstract**

A method and apparatus for correcting a capacity of a battery module and a computer device are provided. The method includes: obtaining a discharge voltage value of the battery module; determining the discharge voltage value as an initial voltage indicator if it is within a dynamic voltage range of fully discharging; obtaining an initial charging capacity corresponding to the initial voltage indicator; obtaining a charging voltage value; determining the charging voltage value as a final voltage indicator if it is within a dynamic voltage range of fully charging; obtaining a final charging capacity corresponding to the final voltage indicator; determining a total capacity based on the initial and final charging capacity; and correcting the capacity based on the total capacity to obtain a corrected capacity of the battery module. This method ensures the consistency of the capacity of each module in the system and improves the user experience.

## Description

### FIELD

The present disclosure relates to the technical field of battery modules, and in particular to a method for correcting a capacity of a battery module, an apparatus for correcting a capacity of a battery module, and a computer device.

### BACKGROUND

Currently, a residential battery module system includes multiple battery modules stacked in series, with each module containing multiple cells connected in series. The battery capacity is a vital parameter for indicating its status. It is crucial for effective battery management to accurately calculate this capacity.

In conventional technology, the output capacity of the battery system is calculated based on the battery pack which includes all battery modules. In practice, the capacity consistency of the battery is far from satisfaction due to performance disparities among different batches of cells. Managing capacity at battery module level restricts the total capacity of the battery pack, hindering the battery from offering maximum energy efficiency, which can lead to inaccurate state of charge (SOC) and ultimately compromise the user experience.

### SUMMARY

In view of this, there is an interest in providing a method for correcting a capacity of a battery module, an apparatus for correcting a capacity of a battery module, and computer device.

In a first aspect, a method for correcting a capacity of a battery module is provided according to the present disclosure. The method includes:
obtaining a discharge voltage value of the battery module;
determining the discharge voltage value as an initial voltage indicator in response to the discharge voltage value being within a dynamic voltage range of fully discharging ;
obtaining an initial charging capacity of the battery module corresponding to the initial voltage indicator;
obtaining a charging voltage value of the battery module;
determining the charging voltage value as a final voltage indicator in response to that the charging voltage value being within a dynamic voltage range of fully charging;
obtaining a final charging capacity of the battery module corresponding to the final voltage indicator;
determining a total capacity of the battery module based on the initial charging capacity and the final charging capacity; and
correcting the capacity of the battery module based on the total capacity of the battery module to obtain a corrected capacity of the battery module.

In one embodiment, after obtaining the initial charging capacity of the battery module, the method includes:
obtaining a discharge current value of the battery module and/or a temperature value of the battery module; and
stopping correcting the capacity of the battery module, in a case that the discharge current value does not meet a current threshold and/or the temperature does not meet a temperature threshold.

In one embodiment, after stopping correcting the capacity of the battery module, the method includes:
obtaining an updated discharge voltage value of the battery module;
determining the updated discharge voltage value as an updated initial voltage indicator in response to the updated discharge voltage value being within the dynamic voltage range of fully discharging;
obtaining an updated initial charging capacity of the battery module corresponding to the updated initial voltage indicator; and
determining the total capacity of the battery module based on the updated initial charging capacity and the final charging capacity.

In one embodiment, the dynamic voltage range of fully discharging ranges from a voltage value in a fully discharged state to an end-of-discharge voltage value.

In one embodiment, the dynamic voltage range of fully charging ranges from a voltage value in a fully charged state to an end-of-charge voltage value.

In one embodiment, the correcting the capacity of the battery module based on the total capacity of the battery module to obtain the corrected capacity of the battery module includes:
filtering the total capacity;
determining an upper limit of the capacity and a lower limit of the capacity of the battery module, based on a rated capacity of the battery module; and
determining the corrected capacity of the battery module based on the upper limit of the capacity and the lower limit of the capacity.

In a second aspect, an apparatus for correcting a capacity of a battery module is provided according to the present disclosure. The apparatus includes:
a first obtaining module, configured to obtain a discharge voltage value of the battery module;
a first determination module, configured to determine the discharge voltage value as an initial voltage indicator in response to the discharge voltage value being within a dynamic voltage range of fully discharging, and obtain an initial charging capacity of the battery module corresponding to the initial voltage indicator;
a second obtaining module, configured to obtain a charging voltage value of the battery module;
a second determination module, configured to determine the charging voltage value as a final voltage indicator in response to the charging voltage value being within a dynamic voltage range of fully charging, and obtain a final charging capacity of the battery module corresponding to the final voltage indicator; and
a correction module, configured to determine a total capacity of the battery module based on the initial charging capacity and the final charging capacity, and correct the capacity of the battery module based on the total capacity of the battery module to obtain a corrected capacity of the battery module.

In a third aspect, a computer device including a memory and a processor is provided according to the present disclosure, where the memory stores a computer program, and the processor, when executing the computer program, implements the method for correcting the capacity of the battery module above.

In a fourth aspect, a computer-readable storage medium is provided according to the present disclosure. The computer-readable storage medium stores a computer program thereon, where the computer program, when executed on a processor, implements the method for correcting the capacity of the battery module above.

In a fifth aspect, a computer program product including a computer program is provided according to the present disclosure. Where, the computer program, when executed on a processor, implements the method for correcting the capacity of the battery module above.

The method for correcting a capacity of a battery module described hereinabove at least includes beneficial effects as follows.

With the embodiments provided in the present disclosure, a dynamic voltage range of fully discharging and a dynamic voltage range of fully discharging are provided, which guarantees that each module can set up an initial indicator and a final indicator. By recording an initial charging capacity and a final charging capacity of each module based on the initial indicator and the final indicator, the total capacity of the battery module can be obtained in the charging process. The capacity of the battery module is, then, corrected to obtain the corrected capacity of the battery module.

It should be understood that the above general description and the detailed description hereinafter are only illustrative and explanatory and do not limit the present disclosure.

### BRIEF DESCRIPTION OF THE DRAWINGS

In order to more clearly illustrate the technical solutions according to embodiments of the present disclosure or conventional techniques, drawings to be applied in embodiments of the present disclosure or conventional techniques are briefly described hereinafter. Apparently, the drawings in the following descriptions are only some embodiments of the present disclosure, and other drawings may be obtained by those skilled in the art based on the provided drawings without creative efforts.
Figure 1 is a diagram of an application environment of a method for correcting a capacity of a battery module according to an embodiment of the present disclosure;
Figure 2 is a schematic flowchart of a method for correcting a capacity of a battery module according to an embodiment of the present disclosure;
Figure 3 is a schematic diagram of a method for correcting a capacity of a battery module according to an embodiment of the present disclosure;
Figure 4 is a structural block diagram of an apparatus for correcting a capacity of a battery module according to an embodiment of the present disclosure;
Figure 5 is a diagram of an internal structure of a computer device according to an embodiment of the present disclosure; and
Figure 6 is a diagram of an internal structure of a server according to an embodiment of the present disclosure.

### DETAILED DESCRIPTION

In order to better understand the technical solutions for those skilled in the art, combined with the drawings, the technical solutions in the embodiments of the present disclosure are clearly and thoroughly illustrated hereinafter.

It should be noted that the terms such as "first", "second" and the like in the description, the claims and the drawings of the present disclosure are only used to distinguish similar objects, rather than describe a particular or chronological order. It should be understood that the terms used herein may be exchanged as appropriate, such that the embodiments of the present disclosure described herein can be implemented in an order other than the order shown or described herein. The implementations described in the following exemplary embodiments do not represent all implementations that are consistent with the present disclosure. On the contrary, the implementations are merely examples of devices and methods that are described in detail in the appended claims and that are consistent with some aspects of the present disclosure. Terms of "include/including", "comprise/comprising" or any other variants thereof are intended to be non-exclusive. Therefore, a process, method, article or device including a series of elements includes not only these elements but also other elements that are not clearly enumerated, or further includes elements inherent in the process, method, article or device. Unless further restrictions, it is not excluded that there are other identical or equivalent elements in the process, method, product or device that includes the elements. For example, the words such as "first" and "second" are used to indicate the name and do not indicate any particular order.

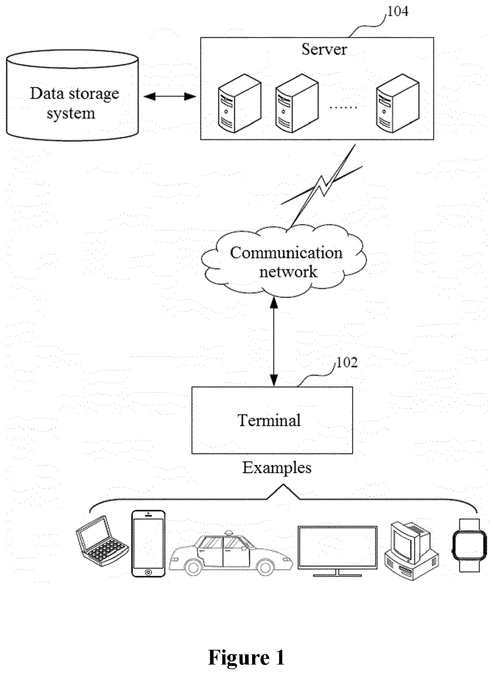

According to an embodiment of the present disclosure, a method for correcting a capacity of a battery module is provided, which is applicable to the environment shown in Figure 1. Where, a terminal 102 communicates with a server 104 through a network. A data storage system may store the data that needs to be processed by the server 104. The data storage system may be integrated on the server 104 or arranged on the cloud or on other network servers. Where, the terminal 102 may be, but is not limited to, various personal computers, laptops, smart phones, tablet computers, Internet of Things devices and portable wearable devices. Internet of Things devices may be smart speakers, smart TVs, smart air conditioners, smart vehicle-mounted devices, etc. Portable wearable devices may be smart watches, smart bracelets, headsets, etc. Server 104 may be implemented with a single server or a cluster of multiple servers.

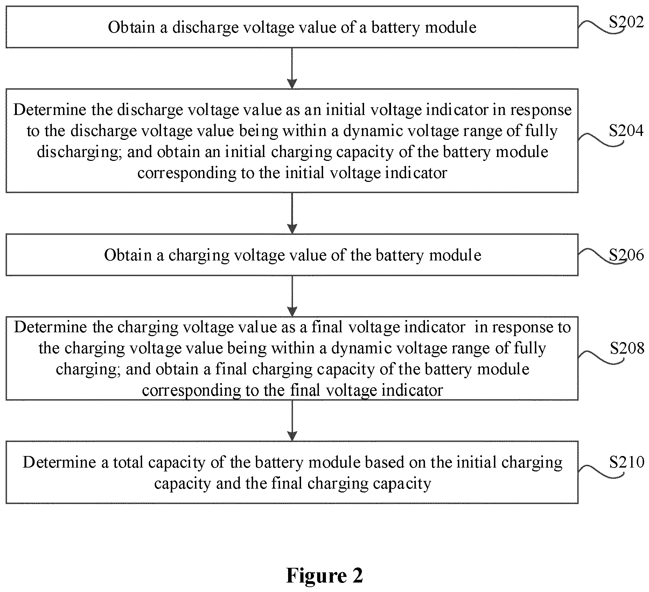

In some embodiments of the present disclosure, as shown in Figure 2, a method for correcting a capacity of a battery module is provided. As an example, the method is applied to the server in Figure 1 to process the voltage value of the battery module. It should be understood that the method may be applied to the server. Alternatively, the method may be applied to a system that includes a terminal and a server, which is implemented through the interaction between the terminal and the server. In a specific embodiment, the method may include the steps S202 to S210 as follows.

In S202, a discharge voltage value of the battery module is obtained.

In S204, in response to the discharge voltage value being within a dynamic voltage range of fully discharging, it is determined that the discharge voltage value as an initial voltage indicator; and an initial charging capacity of the battery module corresponding to the initial voltage indicator is obtained.

The discharge voltage value of the battery module is obtained when the battery module is in the discharge state. And whether the discharge voltage value is in the dynamic voltage range of fully discharging is determined. Where, the dynamic voltage range of fully discharging may range from a voltage value in a fully discharged state to an end-of-discharge voltage value. For the battery, the fully discharging is a state of range, which is not necessarily a fixed threshold in the conventional technology. With this step, it can ensure that each module is in a fully discharged state after discharging. Further, the initial voltage indicator is set and the initial charging capacity of the battery module is recorded. For example, the dynamic voltage range of fully discharging may be [2.7, 2.84] in the unit of volts (V).

In a case that the discharge voltage is within the dynamic voltage range of fully discharging, the discharge voltage value is marked as the initial voltage indicator. In the subsequent charging process, the charging operation starts from the initial voltage indicator and the initial charging capacity of the battery module corresponding to the initial voltage indicator is obtained. There is a certain relationship between the capacity and the voltage of the battery. The battery capacity is one of vital performance indexes to measure battery performance, which indicates the amount of electricity released by the battery under a certain condition (discharge rate, temperature, termination voltage, etc.), i.e., the capacity of the battery. The corresponding initial charging capacity is obtained based on the discharge voltage value corresponding to the initial voltage indicator.

In S206, a charging voltage value of the battery module is obtained.

In S208, in response to the charging voltage value being within a dynamic voltage range of fully charging, it is determined that the charging voltage value as a final voltage indicator; and a final charging capacity of the battery module corresponding to the final voltage indicator is obtained.

The charging voltage value of the battery module is obtained when the battery module is in the charge state. Whether the charging voltage value is in the dynamic voltage range of fully charging is determined. Where, the dynamic voltage range of fully charging may range from a voltage value in a fully charged state to an end-of-charge voltage value. With this step, it can ensure that each module is in a fully charged state after charging. Further, the final voltage indicator is set and the final charging capacity of the battery module is recorded. For example, the dynamic voltage range of fully charging may be [3.56, 3.65] in the unit of volts (V).

In a case that the charging voltage value is within the dynamic voltage range of fully charging, the charging voltage value is marked as the final voltage indicator, and the charging capacity of the battery module corresponding to the final voltage indicator is obtained. The corresponding charging capacity is obtained based on the charging voltage value corresponding to the final voltage indicator.

In S210, based on the initial charging capacity and the final charging capacity, a total capacity of the battery module is determined; and based on the total capacity of the battery module, the capacity of the battery module is corrected to obtain a corrected capacity of the battery module.

The total capacity of the battery module = the final charging capacity - the initial charging capacity. The calculated total capacity may be filtered to guarantee an upper limit of the capacity and a lower limit of the capacity, and the corrected capacity of the battery module is obtained.

In the method for correcting a capacity of a battery module above, a dynamic voltage range of fully discharging and a dynamic voltage range of fully charging can be provided, which guarantees that each module can set up an initial indicator and a final indicator. By recording an initial charging capacity and a final charging capacity of each module based on the initial indicator and the final indicator, the total capacity of the battery module can be obtained in the charging process. The capacity of the battery module is, then, corrected to obtain the corrected capacity of the battery module.

In some embodiments of the present disclosure, after obtaining the initial charging capacity, the method further includes:
obtaining a discharge current value of the battery module and/or a temperature value of the battery module; and
stopping correcting the capacity of the battery module in a case that the discharge current value does not meet a current threshold and/or the temperature does not meet a temperature threshold.

The battery capacity is a vital index to measure the battery performance. And, the battery capacity can be affected by various factors. The common factors are as follows: the influence of temperature on the battery capacity, and the influence of discharge current on the battery capacity. The battery capacity decreases with the increase of the discharge rate, i.e., the larger the discharge current is, the smaller the calculated battery capacity is. Hence, the battery capacities are different under different discharged rates. In addition, the temperature has a greater influence on the battery capacity. Generally, the capacity decreases with the decrease of temperature. The relationship between the capacity and the temperature may be: Ct1=Ct2/1+k(t1-t2). Where, t1 and t2 are the temperature of the electrolyte; k is the temperature coefficient of the capacity; Ctl is the capacity (Ah) when the temperature is t1, and Ct2 is the capacity (Ah) when the temperature is t2. In an embodiment, in a case that the discharge current value does not meet a current threshold, correction operation for the capacity of the battery module is stopped. In another embodiment, in a case that the temperature does not meet a temperature threshold, correction operation for the capacity of the battery module is stopped. Alternatively, in a case that the discharge current value does not meet a current threshold and the temperature does not meet a temperature threshold, the correction operation for the capacity of the battery module is stopped.

As an example, in a case that the discharge current value is less than the current threshold, it may indicate that the discharge current of the battery module does not meet the current threshold. In a case that the temperature value of the battery module is greater than the temperature threshold, it may indicate that the temperature of the battery module does not meet the temperature threshold. Such example is only for illustration rather than a limitation to the present disclosure.

In some embodiments of the present disclosure, after the stopping correcting the capacity of the battery module, the method further includes:
obtaining an updated discharge voltage value of the battery module;
determining the updated discharge voltage value as an updated initial voltage indicator in response to the updated discharge voltage value being within a dynamic voltage range of fully discharging; and obtaining an updated initial charging capacity of the battery module corresponding to the updated initial voltage indicator; and
the process of determining a total capacity of the battery module based on the initial charging capacity and the final charging capacity includes: determining the total capacity of the battery module based on the updated initial charging capacity and the final charging capacity.

In a case that the discharge current value does not meet a current threshold and/or the temperature does not meet a temperature threshold, the correction operation for the capacity of the battery module is stopped. In this case, the discharge state can be re-entered, and the updated discharge voltage value of the battery module can be re-obtained. When the updated discharge voltage value is within the dynamic voltage range of fully discharging, the updated discharge voltage value is determined as the updated initial voltage indicator. Accordingly, the updated initial charging capacity of the battery module corresponding to the updated initial voltage indicator is obtained. Ultimately, the total capacity of the battery module is determined based on the updated initial charging capacity and the final charging capacity.

In some embodiments of the present disclosure, the dynamic voltage range of fully discharging ranges from a voltage value in a fully discharged state to an end-of-discharge voltage value.

Where, a voltage of the battery in a fully discharged state refers to the lowest working voltage value when the voltage drops during battery discharge to a level where it is not advisable to continue discharging the battery. The voltage in a fully discharged state varies depending on the type of battery and the discharge conditions. During discharge, after continuous discharge, while waiting for the battery current to return to zero, the open-circuit voltage of the battery is obtained as the end-of-discharge voltage. In a case that the discharge voltage value of the battery module falls within the dynamic voltage range of fully discharging, it is considered that the battery is currently in a fully discharged state, ensuring that all battery modules can set their respective initial voltage indicators.

In some embodiments of the present disclosure, the dynamic voltage range of fully charging ranges from a voltage value in a fully charged state to an end-of-charge voltage value.

In a case that the charging voltage of the battery module is within the dynamic voltage range of fully charging, it is considered that the battery is currently in a fully charged state, ensuring that all battery modules can set their respective final voltage indicators.

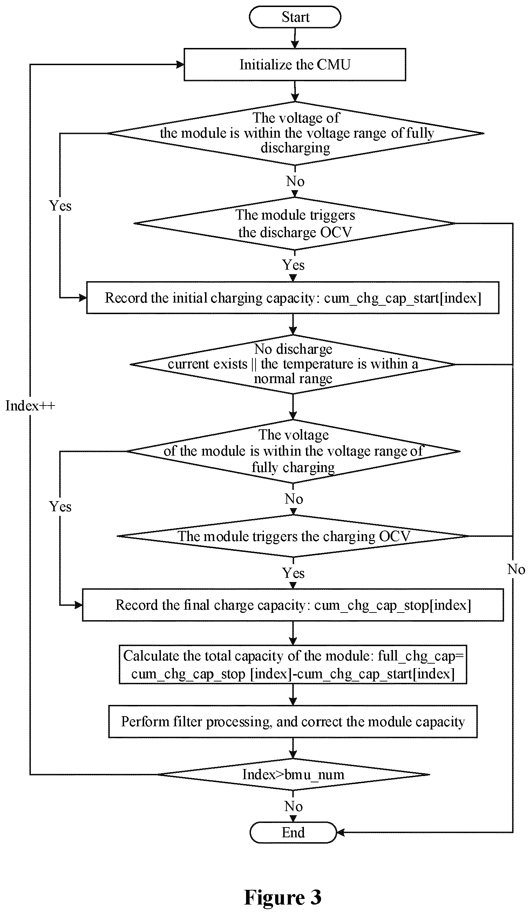

In some embodiments of the present disclosure, Figure 3 is a schematic diagram of a method for correcting a capacity of a battery module according to an embodiment of the present disclosure. The process of correcting the capacity of the battery module based on the total capacity of the battery module to obtain a corrected capacity of the battery module includes:
filtering the total capacity of the battery module;
determining an upper limit of the capacity of the battery module and a lower limit of the capacity of the battery module, based on a rated capacity of the battery module; and
determining the corrected capacity of the battery module based on the upper limit of the capacity of the battery module and the lower limit of the capacity of the battery module.

The battery pack capacity = module capacity = cell capacity × the number of cells in parallel. With the increase of cycle charging and discharge times and the change of working environment, inconsistency exists between cell voltage, capacity and internal resistance. This reduces the battery capacity and affects the battery service life. The upper limit and lower limit of the capacity of the battery module can be determined by the total capacity of multiple battery modules. Before correction, when a module reaches the end-of-discharge voltage (lower limit protection voltage), other modules still having a certain amount of power cannot continue to discharge; and when a module reaches the end-of-charge voltage (upper limit protection voltage), other modules still having a certain amount of power cannot continue to charge. As a result, the total battery capacity is decreased before correction. After correction, the total battery capacity is increased as the power difference is increased. The capacity of each module corrected in a dynamic voltage range ensures the consistency of the capacity of each module in the system and improves the user experience. For the calculated total capacity, the allowable upper and lower limit truncation processing and each time capacity correction step size processing are performed. For example, the rated capacity is 50Ah, and the corrected capacity is required to be within [40, 60].

It should be understood that, although the individual steps in the flowchart involved in each embodiment described above are shown sequentially as indicated by arrows, these steps are not necessarily executed sequentially in the order indicated by arrows. Unless explicitly stated herein, no strict order in which these steps can be performed is required, and these steps can be executed in other sequences. Furthermore, at least a part of the steps in the flowchart involved in each embodiment described above may include multiple steps or multiple stages, and these steps or stages are not necessarily executed at the same moment to complete, but can be executed at different moments, and the order of executing these steps or stages is not necessarily sequential, rather, can be executed in turn or alternately with at least a part of the steps or stages in other steps or other steps.

Based on the same concept, an apparatus for correcting a capacity of a battery module is also provided by the embodiment of the present disclosure, which is used to implement the method for correcting a capacity of a battery module above. Since the implementation solution for solving problems provided by the apparatus is similar to the implementation solution described in the method mentioned above, the specific limitation on the apparatus for correcting a capacity of a battery module provided by the embodiment may refer to the limitation of the method for correcting a capacity of a battery module above, which will not be repeated here.

The apparatus may include a system (including a distributed system), software (applications), a module, an assembly, a server, a client and the like that use the method described in embodiments of this specification and is combined with necessary implementation hardware. Based on the same concept, the apparatus in one or more embodiments provided in the present embodiment is described in the following embodiments. Since the implementation solution for solving problems provided by the apparatus is similar to the implementation solution described in the method, the specific implementation for the apparatus provided by the embodiment of the specification may be referred to the implementation of the method mentioned above, which will not be repeated here. The terms "unit" or "module" used hereinafter, can implement a predetermined function in software and/or combined with hardware. Although the apparatus described in the following embodiment is preferably implemented in software, the implementation of hardware, or a combination of software and hardware, is also possible and considered.

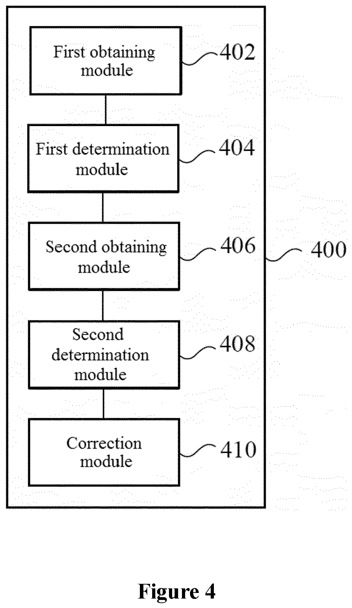

In one embodiment, as shown in Figure 4, an apparatus 400 for correcting a capacity of a battery module is provided. The apparatus may be the server mentioned above, or a module, assembly, device, unit and the like integrated in the server. The apparatus 400 may include: a first obtaining module 402, a first determination module 404, a second obtaining module 406, a second determination module 408 and a correction module 410 as follows.

The first obtaining module 402 is configured to obtain a discharge voltage value of a battery module;

The first determination module 404 is configured to determine the discharge voltage value as an initial voltage indicator in response to the discharge voltage value being within a dynamic voltage range of fully discharging; and obtain an initial charging capacity of the battery module corresponding to the initial voltage indicator.

The second obtaining module 406 is configured to obtain a charging voltage value of the battery module.

The second determination module 408 is configured to determine the charging voltage value as a final voltage indicator in response to the charging voltage value being within a dynamic voltage range of fully charging; and obtain a final charging capacity corresponding to the final voltage indicator.

The correction module 410 is configured to determine a total capacity of the battery module based on the initial charging capacity and the final charging capacity; and correct the capacity of the battery module based on the total capacity of the battery module to obtain a corrected capacity of the battery module.

With regard to the apparatus in the above-mentioned embodiment, the specific mode in which each module performs the operation is described in detail in the embodiments related to the method, which will not be described in detail here.

Each module in the apparatus for correcting a capacity of a battery module described above can be implemented all or partly by software, hardware and/or their combination. The modules mentioned above can be embedded in or independent from the processor of the computer device in the form of hardware, and can also be stored in the memory in the computer device in the form of software, so that the processor can invoke operations corresponding to modules above.

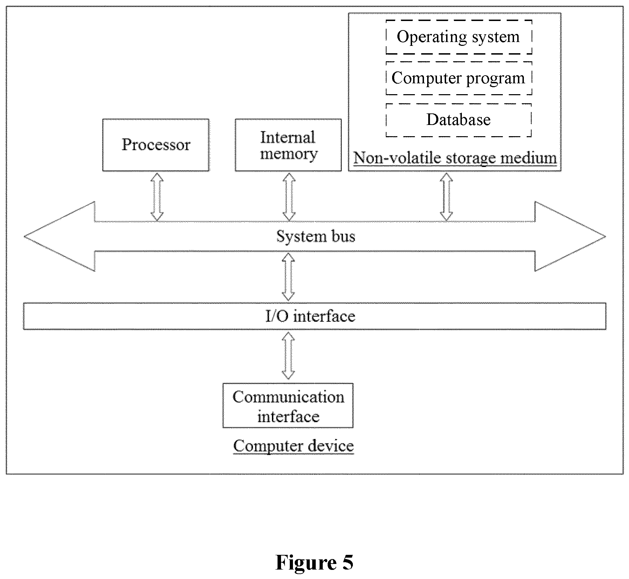

In one embodiment, a computer device is provided. The computer device may be a server, and its internal structure diagram may be referred to Figure 5. The computer device includes a processor, a memory, and a network interface connected by a system bus. Where, the processor of the computer device is used to provide computing and control capabilities. The memory of the computer device includes a non-volatile storage medium and an internal memory. The non-volatile storage medium stores an operating system, a computer program, and a database. The internal memory provides the environment for the operation of the operating system and the computer program in the non-volatile storage medium. The database of the computer device is used to store the voltage of the battery module. The network interface of this computer device is used for communicating with external terminals through network connections. This computer program is executed by the processor to implement the method for correcting a capacity of a battery module.

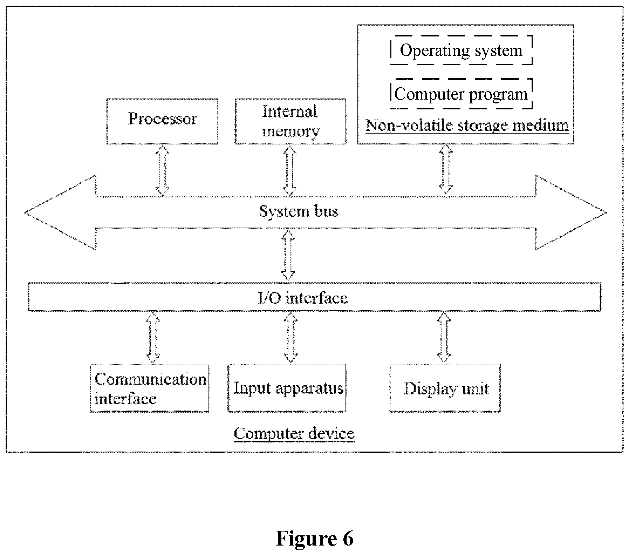

In one embodiment, a computer device is provided, and the computer device may be a terminal, and its internal structure diagram may be referred to Figure 6. The computer device includes a processor, a memory, a communication interface, a display screen, and an input apparatus connected through a system bus. Where, the processor of the computer device is used to provide computing and control capabilities. The memory of the computer device includes a non-volatile storage medium and an internal memory. The non-volatile storage medium stores an operating system, a computer program. The internal memory provides the environment for the operation of the operating system and the computer program in the non-volatile storage medium. The communication interface of this computer device is used for wired or wireless communication with external terminals, and wireless communication may be realized through WIFI, mobile cellular network, NFC (near field communication) or other technologies. This computer program is executed by the processor to implement the method for correcting a capacity of a battery module. The display screen of the computer device may be a liquid crystal display screen or an electronic ink display screen. The input apparatus of the computer device may be a touch layer covered on the display screen, may also be a key, a trackball or a touchpad that is set on the shell of the computer device, and may also be an external keyboard, touchpad or mouse, etc.

Those skilled in the art may understand that the structures shown in Figure 5 and Figure 6 are merely block diagrams of the structures related to the solutions of present disclosure, which do not constitute a limitation of the computer device to which the present disclosure scheme is applied. The specific computer device may include more or fewer parts than those shown in the figure, or combine certain parts, or arrange parts differently.

In one embodiment, a computer-readable storage medium is provided. The computer-readable storage medium stores a computer program thereon. The computer program, when executed by a processor, implements the method for correcting a capacity of a battery module according to any embodiment of the present disclosure.

In one embodiment, a computer program product is provided, including a computer program, where the computer program, when executed by a processor, implements the method for correcting a capacity of a battery module according to any embodiment of the present disclosure.

Those skilled in the art may understand that all or part of the processes in the method mentioned above according to the embodiments can be completed through the related hardware controlled by the computer program. The computer program may be stored in a non-volatile computer-readable storage medium. The steps of the foregoing method in the embodiments may be included when the computer program is executed. Any reference to a memory, a database, or other medium used in the embodiments according to the present disclosure may include at least one of a non-volatile memory and a volatile memory. The non-volatile memory may include a read-only memory (ROM), tape, floppy disk, flash memory, optical memory, high-density embedded non-volatile memory, resistive random access memory (ReRAM), magnetoresistive random access memory (MRAM), ferroelectric random access memory (FRAM), phase change memory (PCM), graphene memory, etc. The volatile memory may include a random access memory (RAM) or external cache memory. As an illustration rather than a limitation, RAM may be in many forms, such as a static random access memory (SRAM) or a dynamic random access memory (DRAM). The database involved in each embodiment provided in the present disclosure may include at least one of a relational database and a non-relational database. The non-relational database may include a distributed database based on blockchain, and the like, which is not limited in the present disclosure. The processor involved in each embodiment provided in the present disclosure may be a general-purpose processor, a central processing unit, a graphic processor, a digital signal processor, a programmable logic device, a data processing logic device based on quantum computing, etc., which are not limited in the present disclosure.

The technical features of the above embodiments can be arbitrarily combined. For simplicity of description, not all possible combinations of the technical features in the foregoing embodiments are described. In fact, the combinations of these technical features are considered as falling within the protection scope recorded by this specification as long as there is no conflict between the combinations of these technical features.

The foregoing embodiments only describe some implementations of the present disclosure, which are specifically described in detail and are not construed as limitation to the scope of the present disclosure. It should be noted that for those skilled in the art, variations and improvements can be made without departing from the concept of the present disclosure, which fall within the protection scope of the present disclosure. Hence, the protection scope of the present disclosure is in accordance with the appended claims.

## Claims

1. A method for correcting a capacity of a battery module, comprising:
obtaining a discharge voltage value of the battery module;
determining the discharge voltage value as an initial voltage indicator in response to the discharge voltage value being within a dynamic voltage range of fully discharging;
obtaining an initial charging capacity of the battery module corresponding to the initial voltage indicator;
obtaining a charging voltage value of the battery module;
determining the charging voltage value as a final voltage indicator in response to the charging voltage value being within a dynamic voltage range of fully charging;
obtaining a final charging capacity of the battery module corresponding to the final voltage indicator;
determining a total capacity of the battery module based on the initial charging capacity and the final charging capacity; and
correcting the capacity of the battery module based on the total capacity of the battery module to obtain a corrected capacity of the battery module.

2. The method according to claim 1, after obtaining the initial charging capacity of the battery module, the method further comprises:
obtaining a discharge current value of the battery module and/or a temperature value of the battery module; and
stopping correcting the capacity of the battery module, in a case that the discharge current value does not meet a current threshold and/or the temperature does not meet a temperature threshold.

3. The method according to claim 1, after stopping correcting the capacity of the battery module, the method comprises:
obtaining an updated discharge voltage value of the battery module;
determining the updated discharge voltage value as an updated initial voltage indicator in response to the updated discharge voltage value being within the dynamic voltage range of fully discharging;
obtaining an updated initial charging capacity of the battery module corresponding to the updated initial voltage indicator; and
determining the total capacity of the battery module based on the updated initial charging capacity and the final charging capacity.

4. The method according to claim 1, wherein the dynamic voltage range of fully discharging ranges from a voltage value in a fully discharged state to an end-of-discharge voltage value.

5. The method according to claim 1, wherein the dynamic voltage range of fully charging ranges from a voltage value in a fully charged state to an end-of-charge voltage value.

6. The method according to claim 1, wherein the correcting the capacity of the battery module based on the total capacity of the battery module to obtain the corrected capacity of the battery module comprises:
filtering the total capacity;
determining an upper limit of the capacity and a lower limit of the capacity of the battery module, based on a rated capacity of the battery module; and
determining the corrected capacity of the battery module based on the upper limit of the capacity and the lower limit of the capacity.

7. An apparatus for correcting a capacity of a battery module, comprising:
a first obtaining module, configured to obtain a discharge voltage value of the battery module;
a first determination module, configured to determine the discharge voltage value as an initial voltage indicator in response to the discharge voltage value being within a dynamic voltage range of fully discharging, and obtain an initial charging capacity of the battery module corresponding to the initial voltage indicator;
a second obtaining module, configured to obtain a charging voltage value of the battery module;
a second determination module, configured to determine the charging voltage value as a final voltage indicator in response to the charging voltage value being within a dynamic voltage range of fully charging, and obtain a final charging capacity of the battery module corresponding to the final voltage indicator; and
a correction module, configured to determine a total capacity of the battery module based on the initial charging capacity and the final charging capacity, and correct the capacity of the battery module based on the total capacity of the battery module to obtain a corrected capacity of the battery module.

8. A computer device, comprising:
a memory; and
a processor;
wherein the memory stores a computer program, and the processor, when executing the computer program, implements the method for correcting the capacity of the battery module according to any one of claims 1 to 6.

9. A computer-readable storage medium, storing a computer program thereon, wherein the computer program, when executed on a processor, implements the method for correcting the capacity of the battery module according to any one of claims 1 to 6.

10. A computer program product, comprising a computer program, wherein the computer program, when executed on a processor, implements the method for correcting the capacity of the battery module according to any one of claims 1 to 6.
